# EUROPÄISCHE PATENTSCHRIFT

(11) **EP 2 270 875 B1**
(45) Veröffentlichungstag und Bekanntmachung des Hinweises auf die Patenterteilung: **10.01.2018**
(21) Anmeldenummer: 10180345.0
(22) Anmeldetag: 16.03.2001
(51) Int. Cl.: H01L 33/00, H01L 33/32, H01L 33/40, H01L 33/44, H01S 5/00

(54) **Strahlungsmittierendes Halbleiterbauelement und dessen Herstellungsverfahren**
Sermiconductor light emitting device and method of manufacturing the same
Dispositf à semiconducteur émetteur de lumière et son procédé de fabrication

(30) Priorität: 26.04.2000 DE 10020464; 26.05.2000 DE 10026255; 17.10.2000 DE 10051465
(43) Veröffentlichungstag der Anmeldung: 05.01.2011
(62) Teilanmeldung aus: 01931363.4
(73) Patentinhaber: OSRAM Opto Semiconductors GmbH, 93055 Regensburg (DE)
(72) Erfinder: Bader, Stefan, 93080, Pentling - Matting (DE); Hahn, Berthold, 93155, Hemau (DE); Härle, Volker, 93164, Laaber (DE); Lugauer, Hans-Jürgen, 93161, Sinzing (DE); Mundbrod-Vangerow, Manfred, 89335, Oxenbronn (DE); Eisert, Dominik, 93049, Regensburg (DE)
(74) Vertreter: Epping - Hermann - Fischer

(56) Entgegenhaltungen:
- EP-A- 0 404 565
- EP-A- 0 740 376
- EP-A- 0 810 674
- EP-A- 0 871 228
- EP-A- 0 896 405
- EP-A- 0 905 797
- EP-A2- 0 926 744
- DE-A1- 19 830 838
- JP-A- 8 116 090
- JP-A- 11 068 157
- JP-A- H10 150 220
- US-A- 5 157 468
- US-A- 5 862 167
- US-B1- 6 803 603

## Beschreibung

Die Erfindung bezieht sich auf ein strahlungsemittierendes Halbleiterbauelement sowie ein Herstellungsverfahren hierfür.
Strahlungsemittierende Halbleiterbauelemente auf GaN-Basis sind beispielsweise bekannt aus US 5 210 051. Solche Halbleiterbauelemente enthalten einen Halbleiterkörper mit einer aktiven GaN-Schicht, die auf ein SiC-Substrat aufgebracht ist. Kontaktiert ist der Halbleiterkörper vorderseitig an der lichtauskoppelnden GaN-Schicht und rückseitig an dem SiC-Substrat.
Weiterhin ist beispielsweise aus US 5 874 747 bekannt, statt GaN verwandte Nitride sowie darauf basierende ternäre oder quaternäre Mischkristalle zu verwenden. Insbesondere fallen hierunter die Verbindungen AlN, InN, AlGaN, InGaN, InAlN und AlInGaN.
Im Folgenden bezieht sich die Bezeichnung "III-V-Nitrid-Halbleiter" auf diese ternären und quaternären Mischkristalle sowie Galliumnitrid selbst.
Ferner ist bekannt, GaN-Halbleiterkristalle epitaktisch herzustellen. Als Substrat wird üblicherweise ein Saphirkristall oder SiC verwendet. Gemäß US 5 928 421 ist hinsichtlich der Vermeidung von Gitterfehlern ein SiC-Substrat vorzuziehen, da aufgrund der vergleichsweise großen Gitterfehlanpassung zwischen Saphir und GaN die auf Saphir aufgewachsenen GaN-Schichten eine hohe Anzahl von Gitterfehlern aufweisen.

Ein Nachteil von strahlungsemittierenden GaN-Halbleiterbauelementen besteht darin, dass an der Oberfläche, an der die im Halbleiterkörper erzeugte Strahlung ausgekoppelt wird, ein großer Brechungsindexsprung beim Übergang vom Halbleiterkörper zur Umgebung auftritt. Ein großer Brechungsindexsprung führt dazu, dass ein erheblicher Teil der Strahlung wieder in den Halbleiterkörper zurückreflektiert wird und dadurch die Strahlungsausbeute des Bauelements gemindert wird.

Eine Ursache hierfür liegt in der Totalreflexion der erzeugten Strahlung an der Auskoppelfläche. Lichtstrahlen werden vollständig in den Halbleiterkörper zurückreflektiert, falls der Einfallswinkel der Lichtstrahlen auf die Auskoppelfläche größer ist als der Totalreflexionswinkel, bezogen jeweils auf die Oberflächennormale. Mit steigendem Unterschied zwischen dem Brechungsindex des Halbleiterkörpers und der Umgebung sinkt der Totalreflexionswinkel und der Anteil der totalreflektierten Strahlung steigt.

Außerdem werden auch Lichtstrahlen, deren Einfallswinkel kleiner ist als der Totalreflexionswinkel, teilweise in den Halbleiterkörper zurückreflektiert, wobei der zurückreflektierte Anteil um so größer ist, je größer der Brechungsindexunterschied zwischen Halbleiterkörper und Umgebung ist. Ein großer Brechungsindexsprung, wie er bei GaN-Bauelementen auftritt, führt daher zu großen Reflexionsverlusten an der Auskoppelfläche. Die zurückreflektierte Strahlung wird teilweise im Halbleiterkörper absorbiert oder tritt an einer anderen Fläche als der Auskoppelfläche aus, so dass insgesamt die Strahlungsausbeute reduziert wird.

Ein Mittel, die Strahlungsausbeute zu erhöhen, besteht darin, auf das Substrat des Halbleiterkörpers einen Reflektor aufzubringen. Dies ist beispielsweise in DE 43 05 296 gezeigt. Dadurch wird die in den Halbleiterkörper zurückreflektierte Strahlung wiederum in Richtung der Auskoppelfläche gerichtet, so dass der zurückreflektierte Teil der Strahlung nicht verlorengeht, sondern zumindest teilweise nach einer oder mehreren internen Reflexionen ebenfalls ausgekoppelt wird.

Bei strahlungsemittierenden GaN-Bauelementen nach dem Stand der Technik ist es in dieser Hinsicht von Nachteil, ein absorbierendes Substrat wie beispielsweise SiC zu verwenden. Die in den Halbleiterkörper zurückreflektierte Strahlung wird vom Substrat großteils absorbiert, so dass eine Erhöhung der Strahlungsausbeute mittels eines Reflektors nicht möglich ist.

Aus der Patentschrift US 5,786,606 ist ein Herstellungsverfahren für strahlungsemittierende Halbleiterbauelemente auf GaN-Basis bekannt, bei dem auf einem SIMOX-Substrat (Separation by IMplantation of OXygen) oder einem SOI-Substrat (Silicon On Isolator) zunächst eine SiC-Schicht epitaktisch aufgewachsen wird. Auf dieser SiC-Schicht wird danach eine Mehrzahl von GaN-basierenden Schichten abgeschieden.

Durch die SiC-Schicht wird jedoch die Strahlungsausbeute des Bauelements reduziert, da in der SiC-Schicht ein Teil der erzeugten Strahlung absorbiert wird. Weiterhin erfordert auch die epitaktische Ausbildung einer SiC-Schicht mit ausreichender Kristallqualität einen hohen Herstellungsaufwand.

DE 198 30 838 offenbart ein strahlungsemittierendes Halbleiterbauelement, dessen Halbleiterkörper durch einen Stapel unterschiedlicher III-V-Nitrid-Halbleiterschichten gebildet ist und der eine erste Hauptfläche und eine zweite Hauptfläche aufweist, wobei wenigstens ein Teil der erzeugten Strahlung durch die erste Hauptfläche ausgekoppelt wird, wobei auf die zweite Hauptfläche ein Reflektor aufgebracht ist, wobei die Halbleiterschichten auf GaN basieren, wobei die Halbleiterschichten mit dem Reflektor auf einen Träger aufgebracht sind, wobei die Halbleiterschichten frei von einen Aufwachssubstrat sind, und wobei die Halbleiterschichten an ihrer dem Träger abgewandten Oberfläche eine Kontaktfläche aufweisen.

Der vorliegenden Erfindung liegt die Aufgabe zugrunde, ein III-V-Nitrid-Halbleiterbauelement mit erhöhter Lichtausbeute zu schaffen. Weiterhin ist es Aufgabe der vorliegenden Erfindung, ein Verfahren zur Herstellung solcher Halbleiterbauelemente zu entwickeln.
Erfindungsgemäß ist vorgesehen, das strahlungsemittierende Halbleiterbauelement als Dünnschichtbauelement auszubilden, das kein strahlungsabsorbierendes Substrat aufweist. Der Halbleiterkörper des Bauelements ist von einer stapelförmig angeordneten Mehrzahl unterschiedlicher III-V-Nitridhalbleiterschichten gebildet. Im Betrieb erzeugt eine aktive Halbleiterschicht auf GaN-Basis elektromagnetishe Strahlung, die durch eine erste Hauptfläche des Stapels ausgekoppelt wird. Auf eine zweite Hauptfläche des Stapels ist ein Reflektor aufgebracht, so dass der Teil der Strahlung, der bei der Auskopplung zunächst in den Halbleiterkörper zurückreflektiert wird, mittels dieses Reflektors wieder in Richtung der Auskopplungsfläche gerichtet wird.
Damit wird neben dem primär ausgekoppelten Anteil der erzeugten Strahlung ein weiterer Teil nach einer oder mehreren internen Reflexionen an dem Reflektor ausgekoppelt. Insgesamt wird so der Auskopplungsgrad gegenüber einem GaN-Halbleiterbauelement nach dem Stand der Technik erhöht.
In einer bevorzugten Ausführungsform bestehen die GaN-basierenden Halbleiterschichten aus GaN, AlN, InN, AlGaN, InGaN, InAlN oder AlInGaN. Durch Verwendung dieser Materialien kann die Zentralwellenlänge der erzeugten Strahlung in einem weiten Bereich des sichtbaren Spektralbereichs bis in den ultravioletten Spektralbereich eingestellt werden. Mit der vorliegenden Erfindung können so mit besonderem Vorteil blaue und grüne Leuchtdioden, UV-Leuchtdioden sowie entsprechende Laserdioden realisiert werden. Erfindungsgemäß besteht der Reflektor aus einer Al- oder einer Ag-Legierung. In einer weiteren bevorzugten Ausführungsform ist die gesamte freie Oberfläche des Halbleiterkörpers oder ein Teilbereich davon aufgeraut. Durch diese Aufrauung wird die Totalreflexion an der Auskoppelfläche gestört und dadurch mit Vorteil der optische Auskopplungsgrad weiter erhöht.

Bei dem erfindungsgemäßen Herstellungsverfahren wird zunächst auf ein Substrat eine Zwischenschicht aufgebracht. Auf dieser Zwischenschicht wird eine Mehrzahl unterschiedlicher III-V-Nitrid-Halbleiterschichten abgeschieden. Diese Schichten bilden den Halbleiterkörper des Bauelements. Im nächsten Schritt wird von dem so gebildeten Stapel von III-V-Nitrid-Schichten das Substrat einschließlich der Zwischenschicht abgelöst. In einem weiteren Schritt wird auf eine der beiden Hauptflächen des Halbleiterkörpers ein Reflektor aufgebracht.

Bei einer weiteren Ausführungsform wird ein Si-Substrat verwendet, auf das eine SiC-Zwischenschicht aufgebracht ist. SiC eignet sich besonders für die Herstellung von GaNbasierten Bauelementen, da es eine ähnliche Gitterkonstante wie GaN besitzt, so dass auf SiC abgeschiedene Schichten auf GaN-Basis eine geringe Zahl von Gitterfehlern aufweisen.

In einer weiteren besonders bevorzugten Ausführungsform wird die Zwischenschicht mittels eines Waferbonding-Verfahrens aufgebracht und danach abgedünnt. Bei der Verwendung eines Si-Substrats und einer SiC-Zwischenschicht kann vorteilhafterweise der Si-Wafer mit dem SiC-Wafer durch Ausbildung einer SiO₂-Schicht verbunden werden.
Alternativ kann die Zwischenschicht epitaktisch aufgewachsen werden, wodurch besonders homogene Zwischenschichten herstellbar sind.

In einer besonders bevorzugten Weiterbildung der Erfindung wird das Herstellungsverfahren fortgeführt durch eine Aufrauung des Halbleiterkörpers, wobei die gesamte freie Oberfläche des Halbleiterkörpers oder Teilbereiche hiervon aufgeraut werden. Eine bezüglich der Erhöhung der Lichtausbeute besonders effektive Aufrauung wird durch Anätzen des Halbleiterkörpers oder mittels eines Sandstrahlverfahrens hergestellt.
Bei einer weiteren besonders bevorzugten Ausführungsform wird vor dem Abscheiden der III-V-Nitrid-Schichten auf der Zwischenschicht eine Maskenschicht aufgebracht. Diese Maskenschicht strukturiert die Schichten und teilt insbesondere die III-V-Nitrid-Schichten in mehrere, nicht zusammenhängende Bereiche. Dies verhindert mit großem Vorteil Rissbildung und Ablösung der Zwischenschicht vom Substrat. Vorteilhafterweise wird - insbesondere bei Verwendung von SiC als Zwischenschichtmaterial - als Maske eine Oxidmaske ausgebildet.

Bei einem weiteren erfindungsgemäßen Herstellungsverfahren wird eine Mehrzahl von III-V-Nitrid-Schichten epitaktisch auf ein Verbundsubstrat aufgebracht, das einen Substratkörper und eine Zwischenschicht aufweist, wobei der thermische Ausdehnungskoeffizient des Substratkörpers ähnlich oder größer ist als der thermische Ausdehnungskoeffizient der III-V-Nitrid-Schichten. Unter einem Verbundsubstrat ist hierbei ein Substrat zu verstehen, das mindestens zwei Bereiche, den Substratkörper und die Zwischenschicht, enthält und als solches das Ausgangssubstrat für das Epitaxieverfahren darstellt. Insbesondere ist die Zwischenschicht nicht epitaktisch auf den Substratkörper aufgebracht, sondern vorzugsweise durch ein Waferbonding-Verfahren.

Bei einem solchen Verbundsubstrat sind die thermischen Eigenschaften vor allem durch den Substratkörper bestimmt, während davon weitgehend unabhängig die Epitaxieoberfläche und insbesondere deren Gitterkonstante durch die Zwischenschicht festgelegt ist. Somit kann mit Vorteil die Zwischenschicht optimal an die Gitterkonstante der aufzubringenden Schichten angepaßt werden. Zugleich wird durch die Verwendung eines Substratkörpers mit einem ausreichend hohen thermischen Ausdehnungskoeffizienten verhindert, dass nach der Aufbringung der GaN-basierenden Schichten diese in der Abkühlphase zugverspannt werden und sich dadurch Risse in den Schichten bilden. Vorzugsweise wird daher die Zwischenschicht so dünn ausgebildet, dass der thermische Ausdehnungskoeffizient des gesamten Verbundsubstrats im Wesentlichen dem Ausdehnungskoeffizienten des Substratkörpers entspricht. Typischerweise ist dabei der Substratkörper mindestens zwanzigmal dicker als die Zwischenschicht.

Bei einer vorteilhaften Ausgestaltung der Erfindung enthält der Substratkörper SiC, vorzugsweise Polykristallin (Poly-SiC), Saphir, GaN oder AlN. Der thermische Ausdehnungskoeffizient von SiC ist ähnlich dem Ausdehnungskoeffizienten von GaN-basierenden Materialien, die übrigen genannten Materialien weisen einen größeren thermischen Ausdehnungskoeffizienten als GaN-basierende Materialien auf. Damit wird mit Vorteil eine Rissbildung bei der Abkühlung der epitaktisch aufgebrachten Schichten vermieden.

Bei einer bevorzugten Ausgestaltung der Erfindung enthält die Zwischenschicht SiC, Silizium, Saphir, MgO, GaN oder AlGaN. Diese Materialien eignen sich insbesondere zur Ausbildung einer im Wesentlichen monokristallinen Oberfläche mit einer an GaN angepaßten Gitterkonstante. Bevorzugt wird als Epitaxieoberfläche eine Si(111)-Oberfläche oder eine monokristalline SiC-Oberfläche verwendet, auf der die GaN-basierenden Schichten aufgewachsen werden.

Bei einer vorteilhaften Weiterbildung der Erfindung werden die GaN-basierenden Schichten auf einem Verbundsubstrat abgeschieden, bei dem die Zwischenschicht durch ein Waferbonding-Verfahren auf den Substratkörper aufgebracht ist. Vorzugsweise wird zwischen Substratkörper und Zwischenschicht eine Haftschicht, beispielsweise aus Siliziumoxid, ausgebildet.

Mit Waferbonding-Verfahren kann mit Vorteil eine Vielzahl von Materialsystemen kombiniert werden, ohne durch Materialunverträglichkeiten, wie sie beispielsweise beim epitaktischen Aufbringen einer Zwischenschicht auf einen Substratkörper auftreten, limitiert zu sein.
Um eine ausreichend dünne Zwischenschicht zu erhalten, kann dabei auch zunächst eine dickere Zwischenschicht auf den Substratkörper aufgebondet werden, die dann, beispielsweise durch Schleifen oder Spalten, auf die erforderliche Dicke abgedünnt wird.
Bei einer vorteilhaften Weiterbildung der Erfindung wird vor der Abscheidung der III-V-Nitrid-Schichten auf dem Verbundsubstrat eine Maskenschicht ausgebildet, so dass nur auf den von der Maske unbedeckten Bereichen der Epitaxieoberfläche die III-V-Nitrid-Schichten aufwachsen. Dadurch werden mit Vorteil diese Schichten in der Schichtebene unterbrochen und so ein zusätzlicher Schutz gegen Zugverspannung und die damit einhergehende Rissbildung erreicht.
Eine weiter bevorzugte Ausgestaltung der Erfindung besteht darin, die III-V-Nitrid-Schichten nach der Abscheidung auf dem Verbundsubstrat in einzelne Halbleiterschichtstapel zu strukturieren. Danach wird auf die III-V-Nitrid-Halbleiterschichtstapel ein Träger aufgebracht und das Verbundsubstrat abgelöst. Das Verbundsubstrat kann so zumindest zu Teilen wiederverwendet werden. Dies stellt einen besonderen Vorteil bei SiC-Substratkörpern dar, deren Herstellung mit sehr hohen Kosten verbunden ist. Erfindungsgemäß wird ein Dünnschichtbauelement hergestellt. Unter einem Dünnschichtbauelement ist dabei ein Bauelement zu verstehen, das kein Epitaxiesubstrat enthält.

Im Falle von strahlungsemittierenden Halbleiterbauelementen wird so eine Erhöhung der Strahlungsausbeute erzielt, da eine Absorption der erzeugten Strahlung im Epitaxiesubstrat, wie sie insbesondere bei SiC-Substraten auftritt, vermieden wird.

Das eben beschriebene so genannte Umbonden der Halbleiterschichtstapel von dem Verbundsubstrat auf einen Träger kann bei der Erfindung auch in zwei Schritten erfolgen, wobei die GaN-basierenden Halbleiterschichtstapel zunächst auf einen Zwischenträger und dann auf den eigentlichen Träger gebondet werden, so dass abschließend der eigentliche Träger an die Stelle des Verbundsubstrats tritt. Mit Vorteil weisen so hergestellte Halbleiterschichtstapel eine entsprechende Schichtenfolge wie GaN-basierendes Halbleiterkörper mit Epitaxiesubstrat nach dem Stand der Technik auf, so dass für beide Schichtstapel dieselben nachfolgenden Verarbeitungsschritte wie beispielsweise Vereinzeln, Kontaktieren und Einbau in ein Gehäuse herangezogen werden können.

Bei dem Herstellungsverfahren wird auf dem Halbleiterschichtstapel zur Steigerung der Strahlungsausbeute eine Reflektorschicht ausgebildet. Die Strahlungsausbeute bei GaN-basierenden Halbleiterbauelementen wird aufgrund des hohen Brechungsindex von GaN-basierenden Materialien zum Großteil durch Reflexion an den Grenzflächen des Halbleiterkörpers begrenzt. Bei strahlungsemittierenden Halbleiterkörpern ohne absorbierendem Substrat können mit Vorteil durch eine Reflektorschicht die an der Auskoppelfläche reflektierten Strahlungsanteile wiederum auf die Auskoppelfläche zurückgerichtet werden. Damit wird die Strahlungsausbeute weiter erhöht.

Bei einer vorteilhaften Weiterbildung der Erfindung wird zumindest ein Teil der Oberfläche des Halbleiterschichtstapels aufgeraut. Dadurch wird eine Totalreflexion an der Oberfläche gestört und so eine Erhöhung der Strahlungsausbeute erzielt. Vorzugsweise erfolgt die Aufrauung durch Ätzen oder ein Sandstrahlverfahren.

Weitere Merkmale, Vorteile und Zweckmäßigkeiten ergeben sich aus der nachfolgenden Beschreibung in Verbindung mit den Figuren 1 bis 7. Es zeigen:
- Figur 1: eine schematische Schnittansicht eines ersten nicht erfindungsgemäßen Halbleiterbauelements,
- Figur 2: eine schematische Schnittansicht eines zweiten nicht erfindungsgemäßen Halbleiterbauelements,
- Figur 3: eine schematische Darstellung eines ersten nicht erfindungsgemäßen Herstellungsverfahrens und
- Figur 4: eine schematische Darstellung eines zweiten nicht erfindungsgemäßen Herstellungsverfahrens,
- Figur 5: eine schematische Schnittdarstellung eines weiteren nicht erfindungsgemäßen Herstellungsverfahrens,
- Figur 6: eine schematische Schnittdarstellung eines ersten Ausführungsbeispiels eines erfindungsgemäßen Herstellungsverfahrens und
- Figur 7: eine schematische Schnittdarstellung eines zweiten Ausführungsbeispiels eines erfindungsgemäßen Herstellungsverfahrens.

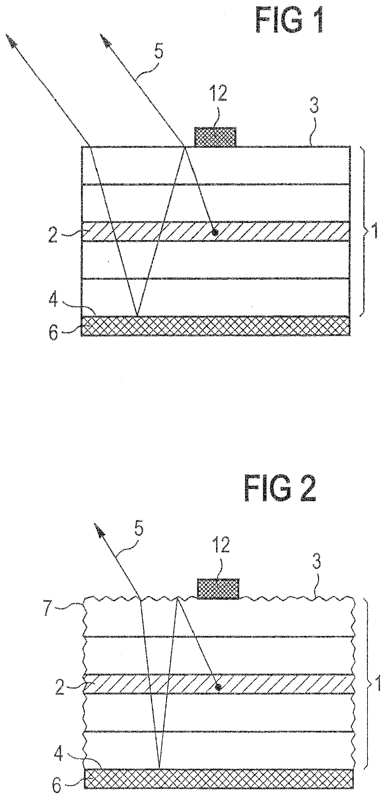

Das in Figur 1 dargestellte nicht erfindungsgemäße strahlungsemittierende Halbleiterbauelement weist eine Mehrzahl von stapelförmig angeordneten, unterschiedlichen Halbleiterschichten 1 auf, die aus GaN oder einer darauf basierenden ternären oder quaternären Verbindung bestehen. Im Betrieb bildet sich innerhalb dieser Schichten eine aktive Zone 2 aus, in der die Strahlung 5 generiert wird.
Der Schichtstapel wird von einer ersten Hauptfläche 3 und einer zweiten Hauptfläche 4 begrenzt. Im Wesentlichen wird die erzeugte Strahlung 5 durch die erste Hauptfläche 3 in die angrenzende Umgebung ausgekoppelt.
Auf der zweiten Hauptfläche 4 ist ein Reflektor 6 aufgebracht, gebildet von einer direkt auf den Halbleiterkörper aufgedampften Ag-Schicht. Kontaktiert wird der Halbleiterkörper auf der Auskopplungsseite über die Kontaktfläche 12 sowie reflektorseitig über die Ag-Reflektorschicht. Die reflektorseitige Kontaktierung kann beispielsweise dadurch erfolgen, dass der Halbleiterkörper reflektorseitig auf einen Metallkörper aufgesetzt ist, der sowohl als Träger wie auch der Stromzuführung dient.
Der Reflektor 6 bewirkt, dass ein Teil der Strahlung 5, die bei der Auskopplung an der ersten Hauptfläche 3 in den Halbleiterkörper zurückreflektiert wird, wiederum in Richtung der ersten Hauptfläche 3 reflektiert wird, so dass insgesamt die durch die erste Hauptfläche 3 ausgekoppelte Strahlungsmenge erhöht wird. Diese Erhöhung wird dadurch ermöglicht, dass das Bauelement als Dünnschichtbauelement ohne strahlungsabsorbierendes Substrat ausgeführt ist und der Reflektor 6 direkt auf dem GaN-Halbleiterkörper aufgebracht ist.

Das in Figur 2 dargestellte nicht erfindungsgemäße Halbleiterbauelement unterscheidet sich von dem in Figur 1 gezeigten Bauelement darin, dass die Oberfläche des Halbleiterkörpers eine Aufrauung 7 aufweist. Diese Aufrauung 7 bewirkt eine Streuung der Strahlung 5 an der ersten Hauptfläche 3, so dass die Totalreflexion an der ersten Hauptfläche 3 gestört wird. Weitergehend verhindert diese Streuung, dass die erzeugte Strahlung durch fortlaufende, gleichartige Reflexionen zwischen den beiden Hauptflächen 3 und 4 beziehungsweise dem Reflektor 6 nach Art eines Lichtleiters geführt wird, ohne den Halbleiterkörper zu verlassen. Somit wird durch die Aufrauung 7 die Lichtausbeute weiter erhöht.

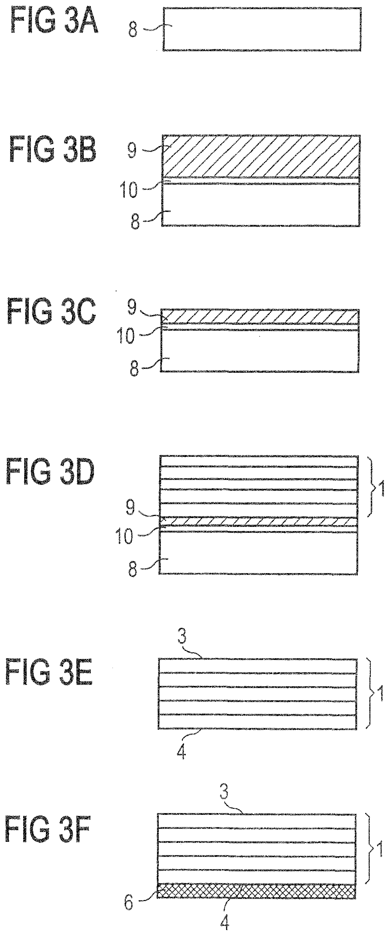

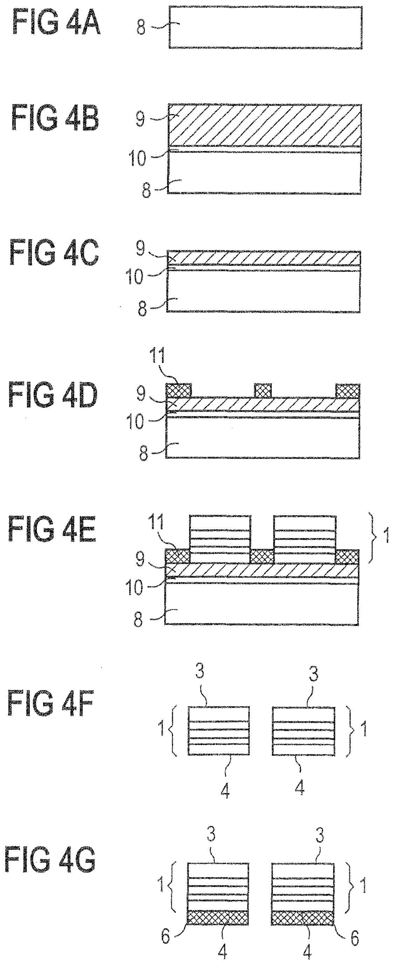

In Figur 3 ist ein erstes nicht erfindungsgemäßes Herstellungsverfahren gezeigt. Den Ausgangspunkt stellt ein Si-Substrat 8 dar, Figur 3a. Auf dieses Si-Substrat wird in einem ersten Schritt eine SiC-Zwischenschicht 9 mittels eines Waferbonding-Verfahrens aufgebracht, wobei zwischen den beiden Substraten eine SiO₂-Schicht 10 ausgebildet wird, Figur 3b. Im nächsten Schritt wird das SiC-Substrat 9 bis auf wenige Mikrometer abgedünnt, Figur 3c. Auf dem abgedünnten SiC-Substrat 9 wird epitaktisch mittels eines MOCVD-Verfahrens eine Mehrzahl unterschiedlicher GaN-Halbleiterschichten 1 abgeschieden, die den Halbleiterkörper des erfindungsgemäßen Bauelements bilden, Figur 3d. Nach der Herstellung des GaN-Schichtstapels wird das Si-Substrat 8 sowie die SiC-Zwischenschicht 9 entfernt, Figur 3e. Danach wird auf eine Hauptfläche 4 des GaN-Halbleiterkörpers eine spiegelnde metallische Kontaktfläche 6, bestehend aus einer Ag- oder Al-Legierung, aufgedampft, Figur 3f.
Um Totalreflexion an der ersten Hauptfläche 3 zu mindern, kann anschließend der Halbleiterkörper durch ein Sandstrahlverfahren oder durch Anätzen mit einer geeigneten Ätzmischung aufgeraut werden. Das in Figur 4 dargestellte nicht erfindungsgemäße Herstellungsverfahren verläuft bis einschließlich des Abdünnens des SiC-Substrats 9 (Figur 4a bis Figur 4c) analog zu dem oben beschriebenen ersten Ausführungsbeispiel. Im Unterschied dazu wird vor dem Abscheiden der GaN-Schichten 1 eine Oxidmaske 11 auf die SiC-Schicht 9 aufgebracht, Figur 4d. Diese Oxidmaske 11 bewirkt, dass im nächsten Schritt die GaN-Schichten 1 nur auf den von der Maske nicht bedeckten Teilbereichen der SiC-Zwischenschicht aufwachsen.
Da die so gebildeten GaN-Schichten 1 entlang der Schichtebene unterbrochen sind, werden Verspannungen, die auf den unterschiedlichen thermischen Ausdehnungskoeffizienten von SiC und GaN beruhen und vor allem bei Abkühlen des Bauelements nach der Herstellung entstehen, vermindert. Dies führt vorteilhafterweise zu einer geringeren Rissbildung in den GaN-Schichten 1 und unterbindet eine Delamination der SiC-Zwischenschicht 9 vom Substrat. Die Herstellung des Reflektors 6, Figur 4g, erfolgt wie oben beschrieben.

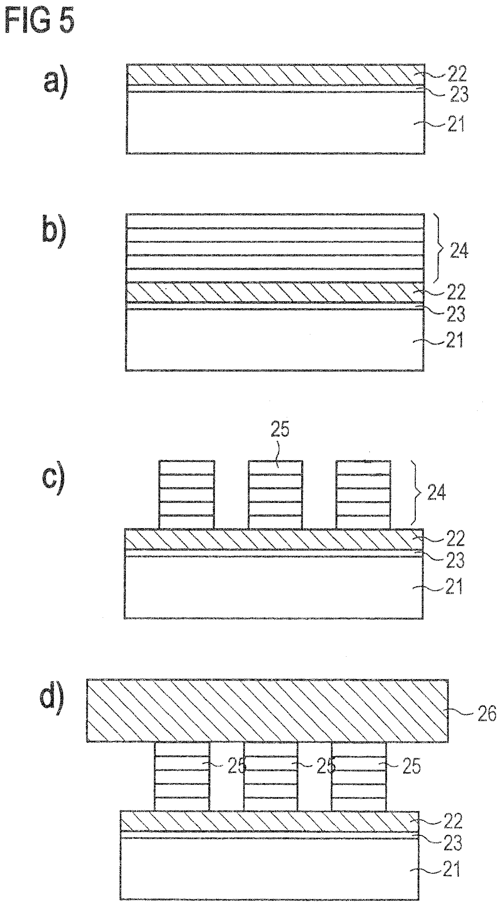

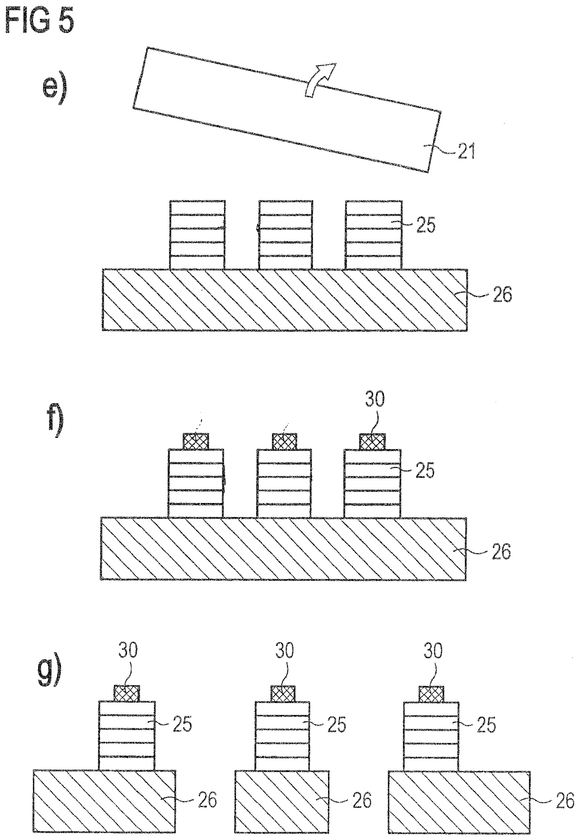

Bei dem in Figur 5 dargestellten nicht erfindungsgemäßen Herstellungsverfahren wird ein Verbundsubstrat mit einem Substratkörper 21 aus Poly-SiC verwendet, auf den in bekannter Weise eine monokristalline SiC-Zwischenschicht 22 aufgebondet ist. Hierzu ist zwischen dem Substratkörper 21 und der Zwischenschicht 22 eine Haftschicht 23, beispielsweise aus Siliziumoxid, ausgebildet, Figur 5a.

Auf dieses Verbundsubstrat wird epitaktisch eine Mehrzahl von GaN-basierenden Schichten 24 aufgewachsen, Figur 5b. Die Struktur der Schichtenfolge ist keinen prinzipiellen Beschränkungen unterworfen.

Vorzugsweise wird hierbei eine aktive, der Strahlungserzeugung dienende Schicht ausgebildet, die von einer oder mehreren Mantelschichten und/oder Wellenleiterschichten umgeben ist.

Die aktive Schicht kann dabei durch eine Mehrzahl von dünnen Einzelschichten in Form einer Einfach- oder Mehrfachquantentopfstruktur ausgebildet sein.

Weiterhin ist es vorteilhaft, auf der Zwischenschicht 22 zunächst eine Pufferschicht, beispielsweise auf AlGaN-Basis, auszubilden, durch die eine verbesserte Gitteranpassung und eine höhere Benetzbarkeit hinsichtlich der folgenden Schichten erreicht werden kann. Um die elektrische Leitfähigkeit einer solchen Pufferschicht zu erhöhen, können in die Pufferschicht elektrisch leitfähige Kanäle, beispielsweise auf InGaN-Basis, eingeschlossen werden.

Anschließend werden die GaN-basierenden Schichten 24 durch eine laterale Strukturierung, vorzugsweise durch eine Mesa-Ätzung, in einzelne Halbleiterschichtstapel 25 unterteilt, Figur 5c.

Auf diese Halbleiterschichtstapel 25 wird im nächsten Schritt, Figur 5d, ein Träger 26, beispielsweise aus GaAs oder einem für die erzeugte Strahlung durchlässigen Material, aufgebracht.

Daraufhin wird das Verbundsubstrat einschließlich der Zwischenschicht 22 von den Halbleiterschichtstapeln 25 abgelöst, Figur 5e. Dies kann beispielsweise durch ein Ätzverfahren erfolgen, bei dem die Zwischenschicht 22 oder die Haftschicht 23 zerstört wird. Mit Vorteil kann der Substratkörper 21 in einem weiteren Herstellungszyklus wiederverwendet werden.
Nachfolgend werden auf die so gebildeten Dünnschichthalbleiterkörper 25 Kontaktflächen 30 aufgebracht, Figur 5f. Abschließend werden die Halbleiterschichtstapel 25 vereinzelt, Figur 5g, und in üblicher Weise weiterverarbeitet.

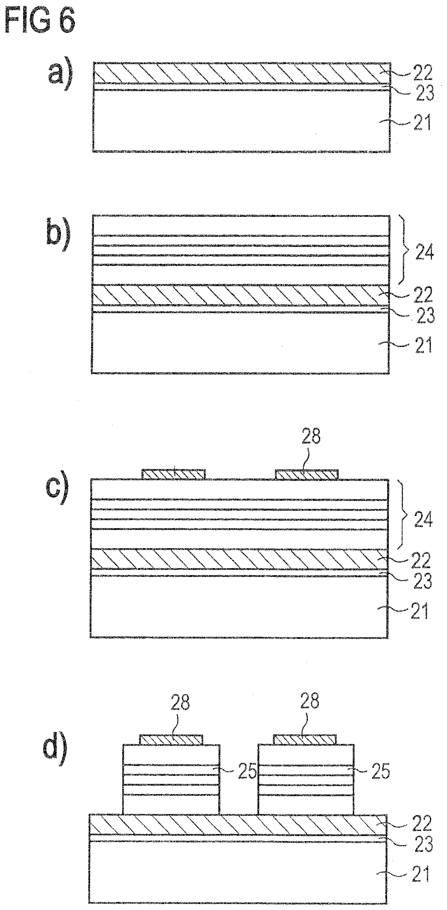

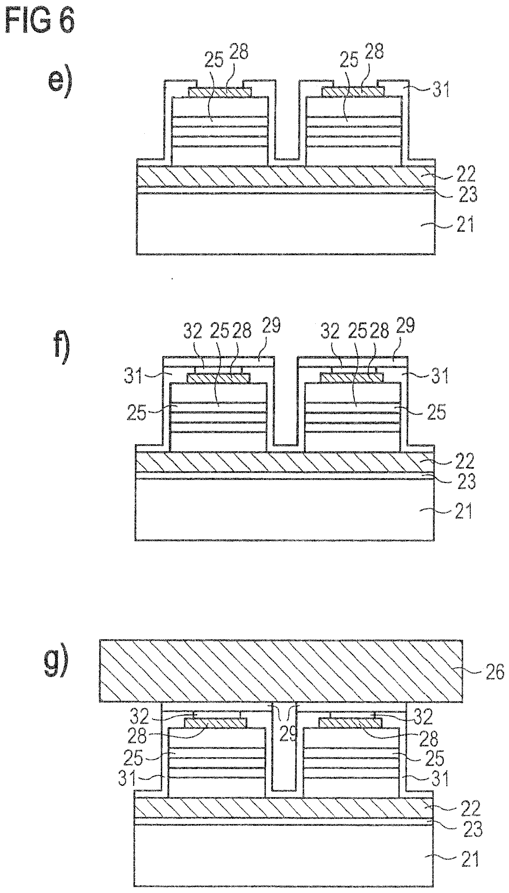

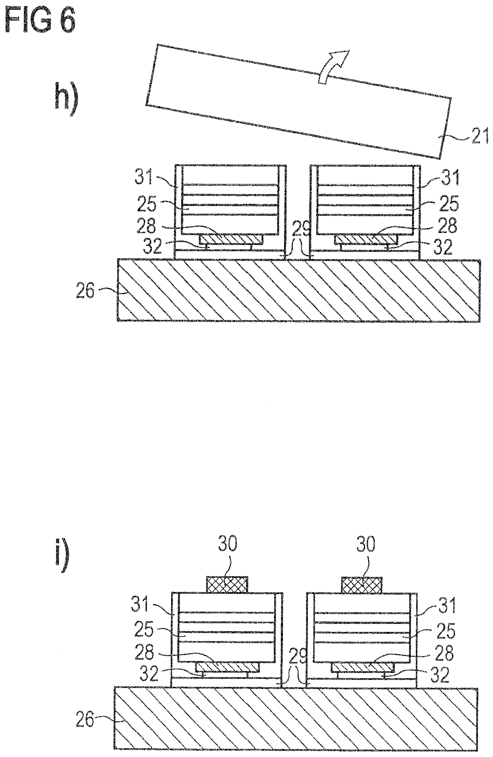

Bei dem in Figur 6 dargestellten ersten Ausführungsbeispiel eines erfindungsgemäßen Herstellungsverfahrens wird wiederum ein Verbundsubstrat verwendet, das im Wesentlichen von einem Poly-SiC-Substratkörper 21 und einer Si(111)-Zwischenschicht 22 gebildet wird. Die Zwischenschicht 22 ist mit Hilfe eines Waferbonding-Verfahrens auf den Substratkörper 21 unter Ausbildung einer Siliziumoxid-Haftschicht 23 aufgebracht, Figur 6a.
Auf dieses Verbundsubstrat wird wiederum eine Mehrzahl von GaN-basierenden Schichten aufgewachsen, Figur 6b, die abschließend mit einer Kontaktschicht 28, beispielsweise aus Platin, versehen wird, Figur 6c.
Nachfolgend werden die GaN-basierenden Schichten 24 durch eine Ätzstrukturierung in einzelne Halbleiterschichtstapel 25 unterteilt, Figur 6d.

Auf diese so gebildeten Halbleiterschichtstapel 25 wird zum Schutz eine Passivierungsschicht 31, vorzugsweise auf Siliziumnitrid-Basis, aufgebracht, Figur 6e.
Auf den nicht von der Passivierungsschicht bedeckten Bereichen der Kontaktschicht 28 wird nun jeweils ein Bondlot 32 und darauf ein Reflektor 29 aus einer Silber- oder Aluminiumlegierung abgeschieden, Figur 6f.
Anschließend werden die Halbleiterschichtstapel 25 mit dem Reflektor 29 eutektisch auf einen Träger 26 umgebondet, Figur 6g.
Im nachfolgenden Schritt, Figur 6h, wird der Substratkörper 21 entfernt und kann so wiederverwendet werden.
Abschließend werden die einzelnen Halbleiterschichtstapel oberseitig mit Kontaktflächen 30 versehen, Figur 6i. Nachfolgend können die Halbleiterschichtstapel vereinzelt und gegebenenfalls in ein Gehäuse eingebaut werden (nicht dargestellt).

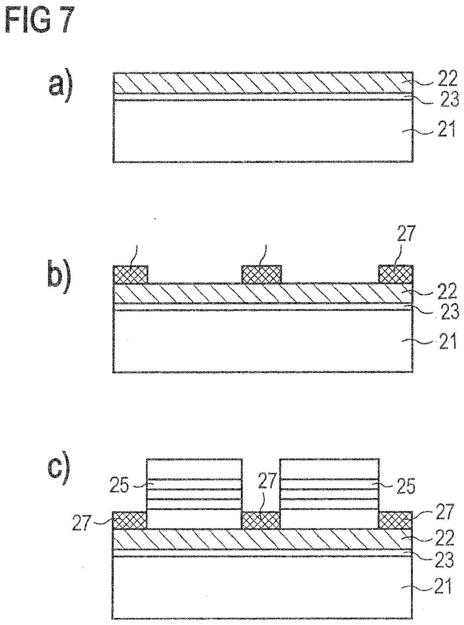

Das in Figur 7 dargestellte zweite Ausführungsbeispiel eines erfindungsgemäßen Herstellungsverfahrens stellt eine Variante der vorigen Ausführungsbeispiele dar.
Wiederum wird, wie bereits beschrieben, als Epitaxiesubstrat ein Verbundsubstrat verwendet, Figur 7a.
Vor der Abscheidung der GaN-basierenden Schichten 24 wird auf die Epitaxieoberfläche der Zwischenschicht 22 eine Maskenschicht 27 aufgebracht, Figur 7b. Die GaN-basierenden Schichten 24 wachsen so nur auf den Bereichen der Epitaxieoberfläche auf, die von der Maskenschicht 27 nicht bedeckt sind (Epitaxiefenster), Figur 7c. Dadurch werden die GaN-basierenden Schichten 24 in Richtung der Schichtebene unterbrochen. So wird zusätzlich eine Zugverspannung in den epitaktisch abgeschiedenen Schichten in der Abkühlphase vermieden.
Nachfolgend kann das Herstellungsverfahren wie in den anderen Ausführungsbeispielen fortgesetzt werden.

## Patentansprüche

1. Strahlungsemittierendes Halbleiterbauelement, dessen Halbleiterkörper durch einen Stapel unterschiedlicher III-V-Nitrid-Halbleiterschichten (24) gebildet ist und der eine erste Hauptfläche und eine zweite Hauptfläche aufweist, wobei wenigstens ein Teil der erzeugten Strahlung durch die erste Hauptfläche ausgekoppelt wird, wobei
- auf die zweite Hauptfläche ein Reflektor (29) aufgebracht ist,
- die Halbleiterschichten (24) auf GaN basieren,
- die Halbleiterschichten (24) mit dem Reflektor (29) auf einen Träger (26) aufgebracht sind,
- die Halbleiterschichten (24) frei von einen Aufwachssubstrat (21) sind, und
- die Halbleiterschichten (24) an ihrer dem Träger (26) abgewandten Oberfläche eine Kontaktfläche (30) aufweisen, dardurch gekennzeichnet, dass
- auf die zweite Hauptfläche eine Kontaktschicht (28) aufgebracht ist,
- auf die Halbleiterschichten (24) eine Passivierungsschicht (31) aufgebracht ist, die die Kontaktschicht (28) stellenweise bedeckt,
- auf die von der Passivierungsschicht (31) nicht bedeckten Bereiche der Kontaktschicht (28) ein Bondlot (32) abgeschieden ist,
- auf das Bondlot der Reflektor (29) abgeschieden ist, wobei der Reflektor (29) aus einer Silberlegierung oder aus einer Aluminiumlegierung besteht, und die Halbleiterschichten (24) mit dem Reflektor (29) eutektisch auf den Träger (26) gebondet sind.

2. Strahlungsemittierendes Halbleiterbauelement nach Anspruch 1, wobei die gesamte freie Oberfläche des Halbleiterkörpers oder ein Teilbereich davon aufgeraut ist.

3. Strahlungsemittierendes Halbleiterbauelement nach Anspruch 2, wobei die gesamte freie Oberfläche des Halbleiterkörpers oder ein Teilbereich davon durch Ätzen aufgeraut ist.

4. Strahlungsemittierendes Halbleiterbauelement nach einem der Ansprüche 1 bis 3, wobei der Halbleiterkörper frei von einem Aufwachssubstrat (21) ist und aus epitaktisch aufgebrachten III-V-Nitrid-Schichten (24) besteht.

5. Strahlungsemittierendes Halbleiterbauelement nach einem der Ansprüche 1 bis 4, wobei das strahlungsemittierende Halbleiterbauelement eine grünes Licht emittierende Laserdiode ist.

6. Verfahren zur Herstellung eines strahlungsemittierenden Halbleiterbauelements nach einem der Ansprüche 1 bis 5, wobei die III-V-Nitrid-Schichten (24) auf ein Verbundsubstrat (21, 22, 23) aufgebracht werden, das einen Substratkörper (21) und eine Zwischenschicht (22) aufweist, wobei der thermische Ausdehnungskoeffizient des Substratkörpers (21) größer ist als der thermische Ausdehnungskoeffizient der III-V-Nitrid-Schichten (24) und die III-V-Nitrid-Schichten (24) auf der Zwischenschicht (22) abgeschieden werden.

## Claims

1. Radiation-emitting semiconductor component, the semiconductor body of which is formed by a stack of different III-V nitride semiconductor layers (24) and which has a first main surface and a second main surface, wherein at least part of the radiation generated is coupled out through the first main surface, wherein
- a reflector (29) is applied to the second main surface,
- the semiconductor layers (24) are based on GaN,
- the semiconductor layers (24) together with the reflector (29) are applied to a carrier (26),
- the semiconductor layers (24) are free of a growth substrate (21), and
- the semiconductor layers (24) have a contact pad (30) at their surface facing away from the carrier (26),
**characterized in that**
- a contact layer (28) is applied to the second main surface,
- a passivation layer (31) is applied to the semiconductor layers (24), said passivation layer covering the contact layer (28) in places,
- a bond solder (32) is deposited onto the regions of the contact layer (28) which are not covered by the passivation layer (31),
- the reflector (29) is deposited onto the bond solder, wherein
the reflector (29) consists of a silver alloy or of an aluminium alloy, and
- the semiconductor layers (24) together with the reflector (29) are eutectically bonded onto the carrier (26).

2. Radiation-emitting semiconductor component according to Claim 1,
wherein the entire free surface of the semiconductor body or a partial region thereof is roughened.

3. Radiation-emitting semiconductor component according to Claim 2,
wherein the entire free surface of the semiconductor body or a partial region thereof is roughened by etching.

4. Radiation-emitting semiconductor component according to any of Claims 1 to 3,
wherein the semiconductor body is free of a growth substrate (21) and consists of epitaxially applied III-V nitride layers (24).

5. Radiation-emitting semiconductor component according to any of Claims 1 to 4,
wherein the radiation-emitting semiconductor component is a laser diode that emits green light.

6. Method for producing a radiation-emitting semiconductor component according to any of Claims 1 to 5,
wherein the III-V nitride layers (24) are applied to a composite substrate (21, 22, 23) comprising a substrate body (21) and an intermediate layer (22), wherein the coefficient of thermal expansion of the substrate body (21) is greater than the coefficient of thermal expansion of the III-V nitride layers (24) and the III-V nitride layers (24) are deposited on the intermediate layer (22).

## Revendications

1. Composant semi-conducteur émettant un rayonnement, dont le corps semi-conducteur est constitué d'un empilement de différentes couches semi-conductrices de nitrures d'éléments III-V (24) et qui présente une première surface principale et une seconde surface principale, au moins une partie du rayonnement produit étant découplée par la première surface principale, dans lequel
- un réflecteur (29) est appliqué sur la seconde surface principale,
- les couches semi-conductrices (24) sont à base de GaN,
- les souches semi-conductrices (24) sont appliquées avec le réflecteur (29) sur un support (26),
- les couches semi-conductrices (24) sont exemptes d'un substrat de croissance (21), et
- les couches semi-conductrices (24) présentent une surface de contact (30) sur leur surface opposée au support (26),
**caractérisé en ce que**
- sur la seconde surface principale est appliquée une couche de contact (28),
- sur les couches semi-conductrices (24) est appliquée une couche de passivation (31) qui recouvre par endroits la couche de contact (28),
- sur les zones de la couche de contact (28) qui ne sont pas recouvertes par la couche de passivation (31) est déposée une brasure de liaisonnement (32),
- le réflecteur (29) est déposé sur la brasure de liaisonnement,
le réflecteur (29) étant constitué d'un alliage d'argent ou d'un alliage d'aluminium,
et les couches semi-conductrices (24) avec le réflecteur (29) étant en liaison eutectique sur le support (26).

2. Composant semi-conducteur émettant un rayonnement selon la revendication 1,
dans lequel l'intégralité de la surface libre du corps semi-conducteur ou une zone partielle de celle-ci est rendue rugueuse.

3. Composant semi-conducteur émettant un rayonnement selon la revendication 2,
dans lequel l'intégralité de la surface libre du corps semi-conducteur ou une zone partielle de celle-ci est rendue rugueuse par attaque chimique.

4. Composant semi-conducteur émettant un rayonnement selon l'une quelconque des revendications 1 à 3,
dans lequel le corps semi-conducteur est exempt d'un substrat de croissance (21) et est constitué de couches de nitrures d'éléments III-V (24) appliquées par épitaxie.

5. Composant semi-conducteur émettant un rayonnement selon l'une quelconque des revendications 1 à 4,
le composant semi-conducteur qui émet un rayonnement étant une diode laser émettant de la lumière verte.

6. Procédé pour la fabrication d'un composant semi-conducteur émettant un rayonnement selon l'une quelconque des revendications 1 à 5,
dans lequel on applique les couches de nitrures d'éléments III-V (24) sur un substrat composite (21, 22, 23) qui comporte un corps de substrat (21) et une couche intermédiaire (22), le coefficient de dilatation thermique du corps de substrat (21) étant supérieur au coefficient de dilatation thermique des couches de nitrures d'éléments III-V (24) et les couches de nitrures d'éléments III-V étant déposées sur la couche intermédiaire (22).
